# EUROPÄISCHE PATENTANMELDUNG

(11) **EP 0 844 761 A2**
(43) Veröffentlichungstag der Anmeldung: **27.05.1998**
(21) Anmeldenummer: 97117609.4
(22) Anmeldetag: 10.10.1997
(51) Int. Cl.: H04L 7/033, H03L 7/08

(54) **Takt- und Datenregeneration hochbitratiger Datensignale**

(30) Priorität: 25.11.1996 DE 19648754
(71) Anmelder: SIEMENS AKTIENGESELLSCHAFT, 80333 München (DE)
(72) Erfinder: Zirwas, Wolfgang, 82194 Gröbenzell (DE)

(57) **Zusammenfassung**

Beim Empfang von Datensignalen mit Bitraten von 10 und mehr Gbit/s besteht das Problem, daß ein großer Phasenjitter auftreten kann. Erfindungsgemäß wird das in drei parallele Signalzüge aufgeteilte Eingangssignal mit einem Taktsignal abgetastet, daß sich vom ersten zum zweiten Signalzug um 180° und vom zweiten zum dritten Signalzug in der Ruhephase nicht unterscheidet, daß dritte Taktsignal aber eine zusätzliche Phasenmodulation erfährt.

## Beschreibung

Die Erfindung betrifft ein Verfahren zur Takt- und Datenregeneration entsprechend dem Oberbegriff des Anspruchs 1 und eine Anordnung zur Durchführung des Verfahrens.

In der älteren deutschen Patentanmeldung 195 23 185.6 ist bereits ein Verfahren zur Takt- und Datenregeneration empfangener Datensignale mit Bitraten größer 10 bis zu 40 Gbit/s beschrieben. Hei diesem Verfahren wird der empfangene Datenstrom in drei parallele Kanäle aufgeteilt, die jeweils mit einem örtlich erzeugten Taktsignal abgetastet werden. Die Ausgangssignale stehen an Signalausgängen zur Verfügung außerdem wird aus zwei der Ausgangssignale mittels Phasenvergleich ein Steuersignal für den lokalen Oszillator erzeugt.

Bei dieser Lösung besteht das Problem, daß mit zunehmender Bandbreite der Phasenregelschleife zur Takterzeugung der Taktjitter größer wird. Selbst bei einer empfohlenen Güte der Phasenregelschleife von 600 bis 1200 und einer entsprechenden 3 dB-Grenzfreqenz der Regelschleife von 8,3 bis 16,6 MHz ergibt sich ein spürbar zunehmender Phasenjitter. Dies rührt daher, daß das Datensignal doppelt abgetastet wird und zusätzlich bei der dritten Abtastung der Takt um halbes Bit zeitversetzt ist. Im Sollzustand, also wenn die zugehörige Phasenregelschleife gefangen hat, liegt dann die ansteigende Flanke der ersten und zweiten Taktsignale in Bitmitte. Das zusätzliche dritte Taktsignal fällt dann durch den Zeitversatz in den Bereich der Datenflanken und im Spektrum des regenerierten Taktsignals erscheint ein breitbandiger Störsockel. Die Störung ist systembedingt, beschränkt sich auf die Bandbreite der Phasenregelschleife und hat eine spektrale Verteilung, die dem Spektrum der Eingangsdatensignale sehr ähnlich ist.

Die Aufgabe der vorliegenden Erfindung besteht also darin, ein Verfahren und eine Anordnung zur Takt- und Datenregeneration zu finden, bei denen möglichst wenig störender Phasenjitter auftritt.

Die Erfindung wird durch ein Verfahren der eingangs erwähnten Art gelöst, das durch die Merkmale des Kennzeichens des Patentanspruchs 1 weitergebildet ist. Wahlweise können bei diesem Verfahren Minimumregelungen nach den Patentansprüchen 2 bis 5 verwendet werden. Im Patentanspruch 6 ist eine Anordnung zur Durchführung des erfindungsgemäßen Verfahrens beschrieben, die in vorteilhafter Weise nur wenig in die Signalübertragung der hochfrequenten Signale eingreift und mit handelsüblichen Bauteilen realisierbar ist. Die Erfindung soll im folgenden anhand eines in der Zeichnung dargestellten Ausführungsbeispieles näher erläutert werden.

Dabei zeigt:
- Figur 1: die erfindungsgemäße Schaltung zur Takt- und Datenregeneration,
- Figur 2: eine typische Kennlinie eines in der Anordnung nach Figur 1 verwendeten Phasendiskriminators nach der Erfindung und
- Figur 3: die NF-Modulation der Taktphase des dritten Taktsignals.

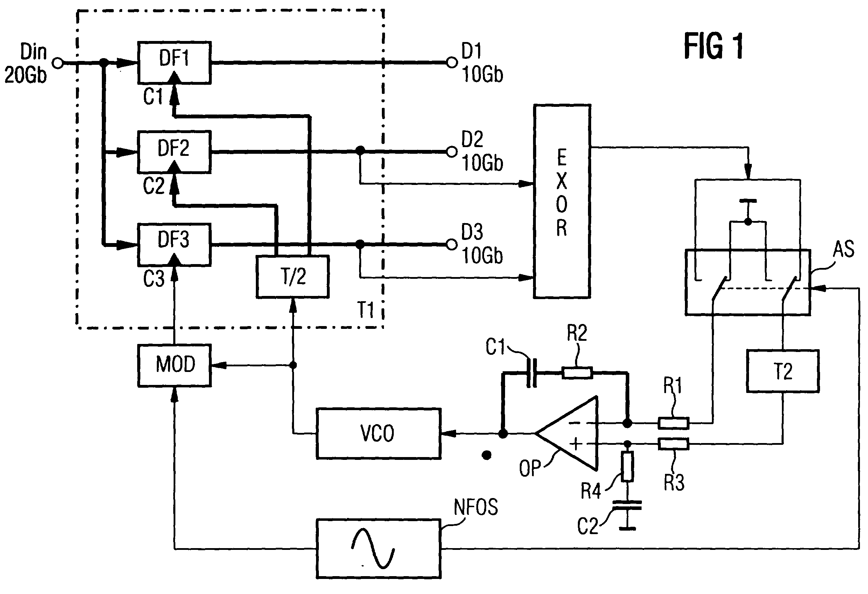

Die in Figur 1 dargestellte Anordnung zur Takt- und Datenregeneration enthält drei D-Flip-Flops DF1...DF3, deren D-Eingänge miteinander und mit einem Dateneingang Din verbunden sind. Jeweils ein nichtinvertierender oder invertierender Ausgang des ersten bis dritten D-Flip-Flops ist mit einem zugeordneten Ausgangsanschluß D1, D2, D3 verbunden. Zusätzlich sind die Ausgangsanschlüsse des zweiten und des dritten D-Flip-Flops DF2, DF3 mit den beiden Eingängen eines als Phasendiskriminators wirksamen Exklusiv-ODER-Gatter EXOR verbunden. Der Ausgangsanschluß des Exklusiv-ODER-Gatters EXOR ist mit Signaleingängen eines analogen Schalters AS verbunden, dessen erster Signalausgang über einen ersten Widerstand R1 mit dem invertierenden Eingang eines Operationsverstärkers OP, der als Integrator geschaltet ist und dazu zwischen dem invertierenden Eingang und dem Ausgang die Reihenschaltung eines zweiten Widerstandes R2 und eines ersten Kondensators C1 enthält. Der zweite Signalausgang des analogen Schalters AS ist über ein zweites Laufzeitglied T2 und einen dritten Widerstand R3 mit dem nichtinvertierenden Eingang des Operationsverstärkers OP verbunden, außerdem ist dieser Eingang über die Reihenschaltung eines vierten Widerstandes R4 und eines zweiten Kondensators C2 mit Bezugspotential verbunden. Der Ausgangsanschluß des Operationsverstärkers OP ist mit dem Steuereingang eines als lokaler Oszillator der Phasenregelschleife eingesetzten spannungsgesteuerten Oszillators VCO verbunden, der beim Ausführungsbeispiel auf einer Frequenz von 10 GHz entsprechend der halben Bitfolgefrequenz der Eingangssignale schwingt. Die Ausgangssignale dieses Oszillators werden an einen Modulator MOD und an ein erstes Laufzeitglied T1 mit einer Verzögerung entsprechend einer halben Birperiode der Eingangssignale abgegeben, dessen Ausgangssignal direkt an den Takteingang des zweiten D-Flip-Flops DFF und über einen Inverter an den Takteingang des ersten D-Flip-Flops DF1 gelangt. Weiterhin ist ein NF-Oszillator NFOS mit einer Schwingfrequenz von einigen 10 MHz vorgesehen, dessen einer Ausgang mit dem Steuersignaleingang des Modulators MOD und dessen anderer Ausgang mit dem Steuersignaleingang des analogen Schalters AS verbunden ist, so daß letzterer im Rhythmus der NF-Schwingung umschaltet. Im Modulator MOD erfolgt eine Modulation des Ausgangssignals des örtlichen Oszillators VCO. Das modulierte Signal ist das dritte Taktsignal C3, das an den Taktsignaleingang des dritten D-Flip-Flops DF3 abgegeben wird. Das Laufzeitglied D1 bewirkt dabei, daß die Phasen des ersten, zweiten Taktsignals genau um 180° verschoben sind und die Phasen des zweiten und dritten Taktsignals genau gleich sind. Da der Zeitversatz zwischen dem zweiten und dritten Taktsignal C2, C3 im Idealfalle 0 ist, wird das Dateneingangssignal vom zweiten und dritten D-Flip-Flop DF2, DF3 an der gleichen Stelle in Bitmitte abgetastet, so daß demnächst noch keine Phaseninformation erhalten wird.

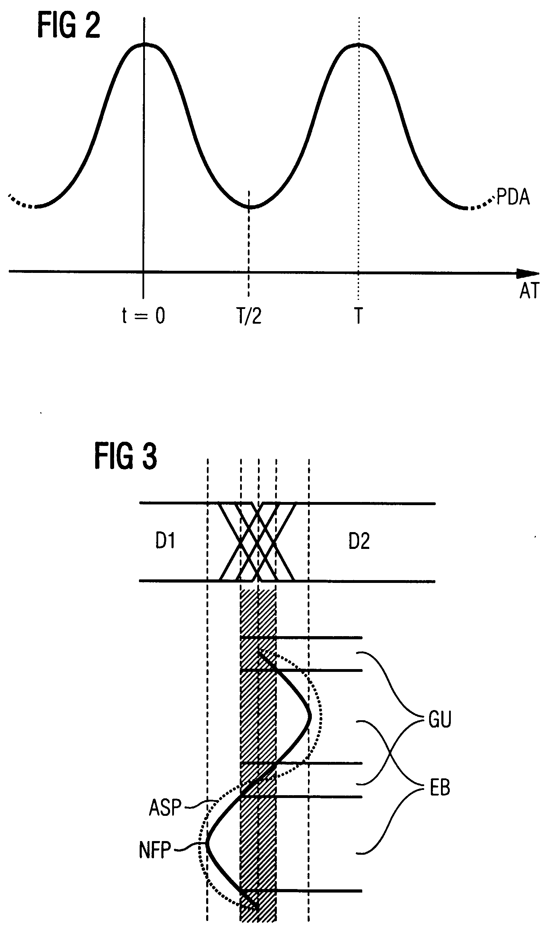

Durch die Phasenmodulation des dritten Taktsignals C3 mit vergleichsweise großem Phasenhub ergibt sich die in Figur 2 dargestellte Phasendiskriminatorkennlinie mit einem Minimum des Ausgangssignals in der Bitmitte. Je mehr der Abtastzeitpunkt aus der Bitmitte herauswandert, desto öfter und desto länger werden in fehlerhafter Weise benachbarte Bits detektiert, wobei dieser Effekt am stärksten ist, wenn der Abtastzeitpunkt auf den Signalflanken der Eingangsdaten liegt. Im Zusammenhang mit einem derartigen Phasendiskriminator wird also eine spezielle Minimumregelung benötigt. Entsprechend der Erfindung wird zur Minimumregelung ein NF-Oszillator NFOS mit einer Schwingfrequenz von 10 bis 100 MHz eingesetzt, der die Phase des dritten Taktsignals C3 moduliert. Für die Minimumregelung werden die beiden Halbperioden, in denen sich die Phase am dritten D-Flip-Flop DF3 links und rechts der Bitmitte befindet, integriert und miteinander verglichen. Der Operationsverstärker OP dient dabei als der Integrator, mit dessen invertierenden und nichtinvertierenden Eingang die Differenz des Ausgangssignals des Phasendetektors gebildet wird, wobei der analoge Schalter AS jeweils die gewünschte Halbperiode auswählt.Durch das zweite Laufzeitglied T2 ergibt sich dabei ein sehr störungsarmer Betrieb, weil durch das Laufzeitglied die Signale während der Halbperioden am Integrator gleichzeitig anliegen.

Bei einer Variante der erfindungsgemäßen Minimumregelung wird der Absolutwert der Phasendiskriminator-Ausgangsspannung zur Regelung herangezogen, zusätzlich kann die Rückstellkraft z.B. exponentiell erhöht werden, so daß mit größerem Abstand zum Minimum eine stärkere Rückstellung erfolgt. Dadurch ist es möglich, bei großen Phasenablagen die Phase des lokalen Oszillators sehr schnell zurückzuregeln.

Bei einer weiteren Möglichkeit zur Minimumregelung wird mit einem Differenzierglied die erste Ableitung des Detektorsignals gebildet, bei Minimum der Phasendiskriminator-Ausgangsspannung wird diese Ableitung gleich 0. Damit das Differenzierglied aber arbeiten kann, muß der Detektor ständig um sein Minimum herum ausgelenkt werden. Dies kann durch eine zusätzliche schnelle Sinusmodulation erfolgen. Damit zusätzlich noch die Richtung bzw. das Vorzeichen der Regelung bestimmt werden kann, ist dann die Ausgangsspannung des Differenziergliedes mit dem Vorzeichen der Sinusmodulation multiplizieren.

In Figur 3 ist die NF-Modulation der Phase des dritten Taktsignals C3 dargestellt. D1 und D2 stellen dabei einzelne Bits des ankommenden Datensignals Din dar, zwischen denen sich insbesondere durch Jitter gestörte Übergangsbereiche GU befinden. Eine eindeutige Bitzuordnung ist also nur in den mit EB bezeichneten Bereichen möglich. Es sind deutliche Unterschiede zwischen der NF-modulierten Phase NFP und der alternativen Signalform ASP für phasenmodulierte Bereiche zu erkennen. Die Bezeichnung der NF-Modulation bezieht sich auf einen Frequenzbereich der NF-Signale von > 10 bis etwa 100 MHz, der zwar nicht absolut, aber gegenüber der Bitfolgefrequenz der Datensignale von 10 und mehr Gbit vergleichsweise niederfrequent ist. Für die Einstellung des Hubs der Phasenmodulation ist wichtig, das dieser verglichen mit dem Jitter an den Flanken des ankommenden Datensignals ausreichend groß ist, da dann die Steilheit der Phasendetektion im wesentlichen vom Modulationshub des NF-Signals und nicht von den Eingangsdaten bestimmt wird. Voraussetzung dabei ist, daß die verwendete Minimumregelung störungsfrei arbeitet, da dann unabhängig von den Eingangsdaten das Minimum der Ausgangsspannung des Phasendiskriminators immer der optimale Abtastzeitpunkt ist. Dabei wirkt die Phasenmodulation des dritten Taktsignals C3 wie die Erzeugung eines Sperrbereichs, innerhalb dessen sich keine Datenflanken befinden dürfen.

Wird der Sperrbereich entsprechend größer als die Set-Up- und Hold-Zeiten der Entscheider D-Flip-Flops gewählt, können bei ausreichend großem Signalhub keine Bitfehler entstehen. Durch den Betrieb der Regelung im Minimum der Phasendiskriminator-Ausgangsspannung ergibt sich dabei der besondere Vorteil, daß auch in der Ausgangsspannung enthaltene Störsignale minimal sind. Dadurch ergibt sich insgesamt ein gegenüber dem Stand der Technik vergleichsweise sehr wenig verjittertes Ausgangssignal. Auch im Hinblick auf beispielsweise am Ausgang des verwendeten Operationsverstärkers auftretenden Offset weist die erfindungsgemäße Lösung besondere Vorteile auf, da sich so auch keine Offsetprobleme ergeben. Ein weiterer Vorteil ergibt sich dadurch, daß die Regelgröße im vorliegenden Fall durch die Integration über einen relativ großen Bereich der Phasendiskriminatorkennlinie nach Figur 2 entsteht. Dadurch ist der Abtastzeitpunkt im Minimum der Phasendiskriminatorkennlinie gut definiert, da der Integralteil in der Nähe der Flanken des Datensignals bereits bei kleinen Abweichungen von der Sollage eine starke Komponente in Richtung des optimalen Abtastzeitpunkts liefert.

## Patentansprüche

1. Verfahren zur Takt- und Datenregeneration empfangener Datensignale, bei dem diese parallel den Eingängen von drei D-Flip-Flops zugeleitet, dort mit jeweils einem örtlich erzeugten Taktsignal abgetastet und anschließend an einen Datenausgang sowie zur örtlichen Erzeugung des Taktsignals an Eingänge eines Phasendiskriminators weitergegeben werden und dabei dem ersten D-Flip-Flop ein erstes Taktsignal, dem zweiten D-Flip-Flop ein zweites und dem dritten D-Flip-Flop ein drittes Taktsignal zugeführt werden,
**dadurch gekennzeichnet,**
daß sich erstes und zweites Taktsignal (CL1, CL2) in der Phase um 180° voneinander unterscheiden, daß die Phasen des zweiten und dritten Taktsignals (CL2, CL3) in der Ruhelage gleich sind, das dritte Taktsignal (CL3) aber zusätzlich phasenmoduliert ist, daß die Phasen des zweiten und dritten Taktsignals (C2, CL3) so eingestellt sind, daß im Sollzustand von diesen Taktsignalen das gleiche Bit in Bitmitte abgetastet wird und dort der verwendete Phasendiskriminator ein Minimum seiner Ausgangsspannung aufweist und daß durch eine Minimum-Regelung die Phase der Taktsignale entsprechend nachgeregelt wird.

2. Verfahren nach Anspruch 1,
**dadurch gekennzeichnet,**
daß zur Minimum-Regelung die Phase des dritten Taktsignals (CL3) um den Abtastzeitpunkt (T/2) moduliert wird und die beiden Halbperioden, in denen sich die Phase des dritten Taktsignals (CL3) links bzw. rechts von T/2 befindet, integriert und miteinander verglichen werden.

3. Verfahren nach Anspruch 1,
**dadurch gekennzeichnet,**
daß zur Minimumregelung mit einem Differenzierglied die erste Ableitung eines der Ausgangssignale der D-Flip-Flops (DFF1, DFF2, DFF3) insbesondere das Ausgangssignal des dritten D-Flip-Flops(DFF3) gebildet wird, wobei diese Ableitung im Minimum der Phasenabweichung gleich Null wird und dabei während der Detektion vor dem Differenzierglied eine zusätzliche schnelle Sinusmodulation angewendet wird, daß zur Erkennung der Richtung bzw. des Vorzeichens der Regelung die Ausgangsspannung des Differenziergliedes mit dem Vorzeichen der Sinusmodulation multipliziert wird, also eine analoge Multiplikation durchgeführt wird.

4. Verfahren nach Anspruch 1,
**dadurch gekennzeichnet,**
daß als Groberkennung des Phasendetektorminimums der Absolutwert der Phasendetektor-Ausgangsspannung dient.

5. Verfahren nach Anspruch 1,
**dadurch gekennzeichnet,**
daß die Rückstellspannung in Abhängigkeit vom Abstand zum Phasendetektorminimum exponentiell erhöht wird, also bei großen Ablagen der Phase des spannungsgesteuerten Oszillators (VCO) diese sehr schnell zurückgeregelt wird.

6. Anordnung zur Durchführung eines Verfahrens nach Patentansprüchen 1 bis 5,
**dadurch gekennzeichnet,**
daß mit einem ersten bis dritten eingangsseitig parallel geschalteten D-Flip-Flop (DF1 ... DF3), deren Ausgänge mit zugeordneten Signalausgängen der Anordnung verbunden sind, bei der die Ausgänge des zweiten und des dritten D-Flip-Flops (DF2, DF3) mit zugeordneten Eingängen eines Exklusiv-ODER-Gatters (EXOR) verbunden sind und der Ausgang des Exklusiv-ODER-Gatters (EXOR) mit Signaleingängen eines als Umschalter wirkenden analogen Schalters (AS) verbunden sind,
daß der erste Signalausgang des analogen Schalters (AS) über einen ersten Widerstand mit dem invertierenden Eingang eines Operationsverstärkers (OP) verbunden ist,
daß der zweite Signalausgang des analogen Schalters (AS) über die Reihenschaltung eines zweiten Laufzeitglieds (T2) mit einer Verzögerung von einer halben Bitperiode der ankommenden Datensignale und einem dritten Widerstand (R3) mit dem nichtinvertierenden Eingang des Operationsverstärkers (OP) verbunden ist und dieser nichtinvertierende Eingang über die Reihenschaltung eines vierten Widerstandes (R4) und eines zweiten Kondensators (C2) mit Bezugspotential verbunden ist,
daß zur Einstellung einer Integratorfunktion der invertierende Eingang des Operationsverstärkers (OP) über die Reihenschaltung eines zweiten Widerstandes (R2) und eines ersten Kondensators (C1) mit dem Ausgang des Operationsverstärkers (OP) und daß dieser Ausgang mit dem Steuereingang eines lokalen Oszillators (VCO) mit einer Schwingfrequenz von 10 GHz verbunden ist,
daß der Ausgang des lokalen Oszillators (VCO) mit dem Eingang eines ersten Laufzeitglieds (T1) und mit dem Eingang für das zu modulierende Signal eines Modulators (MOD) verbunden ist,
daß der Ausgang des Modulators (MOD) mit dem Takteingang des dritten D-Flip-Flops (DF3) verbunden ist, daß ein erster Ausgang des ersten Laufzeitglieds (T1) mit dem Taktsignaleingang des zweiten D-Flip-Flops (DF2) verbunden ist und ein weiterer Ausgang des ersten Laufzeitglieds(T1) über einen Inverter mit dem Taktsignaleingang des ersten D-Flip-Flops verbunden ist,
daß ein NF-Oszillator (NFOS) mit einer Schwingfrequenz von 10 - 100 MHz vorgesehen ist, dessen einer Ausgang mit dem Steuersignaleingang des analogen Schalters (AS) zu dessen rhythmischer Umschaltung und der andere Ausgang des NF-Oszillators (NFOS) mit dem Eingang für das modulierende Signal des Modulators MOD verbunden ist.
